# EUROPEAN PATENT SPECIFICATION

(11) **EP 0 479 191 B1**
(45) Date of publication and mention of the grant of the patent: **13.08.1997**
(21) Application number: 91116659.3
(22) Date of filing: 30.09.1991
(51) Int. Cl.: H03K 19/177

(54) **Dynamic programmable logic array (PLA) in CMOS technology**
Dynamisches programmierbares logisches Feld (PLA) in CMOS-Technik
Réseau logique programmable (PLA) dynamique en technologie CMOS

(30) Priority: 02.10.1990 IT 2162690
(43) Date of publication of application: 08.04.1992
(73) Proprietor: SGS-THOMSON MICROELECTRONICS s.r.l., 20041 Agrate Brianza (Milano) (IT)
(72) Inventor: Scarra', Flavio, I-20041 Agrate Brianza (Milano) (IT); Morganti, Siro Maurizio, I-20056 Trezzo D'Adda (Milano) (IT); Meroni, Giuseppe, I-20041 Agrate Brianza (Milano) (IT)
(74) Representative: Forattini, Amelia

(56) References cited:
- EP-A- 0 132 071
- US-A- 4 661 728
- PATENT ABSTRACTS OF JAPAN vol. 7, no. 233 (E-204)(1378) 15 October 1983;& JP-A-58123230
- IBM TECHNICAL DISCLOSURE BULLETIN. vol. 23, no. 8, January 1981, NEW YORK US
- pages 3533 - 3534; KRAFT ET AL: 'or array reduction technique'

## Description

The present invention relates to a monostabilized dynamic programmable logic array (PLA) in CMOS technology.

As is known, in a typical PLA executed in CMOS technology, cf. US-A-4 661 728, the output lines of the input register enter vertically a so-called AND plane, the output lines whereof enter horizontally a so-called OR plane, and the outputs of the OR plane exit vertically toward an output register. The horizontal output lines of the AND plane are connected to the supply voltage. The horizontal lines of the AND plane are formed by transistors arranged in series and, where required by the combinatorial function, the transistors are controlled by the vertical lines so as to form an AND function. In the OR plane, the vertical lines are the ones connected to the supply voltage, and the transistors arranged at the crossing points are controlled by the horizontal lines in order to connect selected vertical lines to the ground. The lines which enter and exit the AND plane are typically present in a normal version and in a complemented version, in order to be able to obtain any required product term. A two-phase clock alternatively enables the input of the signals to the AND plane and the output of the signals from the OR plane.

The aim of the present invention is to provide a programmable logic array (PLA) structure which allows a better exploitation of the silicon area, with a reduction in occupied space with respect to a PLA having a conventional structure.

An object is to provide said PLA so that its current consumption is markedly lower than that of an equivalent conventional PLA.

The invention achieves this aim,these objects and other objects and advantages, as will become apparent from the following description, with a CMOS programmable logic array having the features set out in claim 1.

The invention is now described in greater detail with reference to a preferred embodiment, illustrated in the accompanying drawing, given by way of example, wherein:
Fig. 1 is a partial circuit diagram of a programmable logic array, or PLA, according to a preferred embodiment of the invention;
Fig. 2 is a plot of the clock signals used for the operation of the programmable logic array of Fig. 1; and
Fig. 3 is a diagram of a circuit for generating the clock signals of Fig. 2.

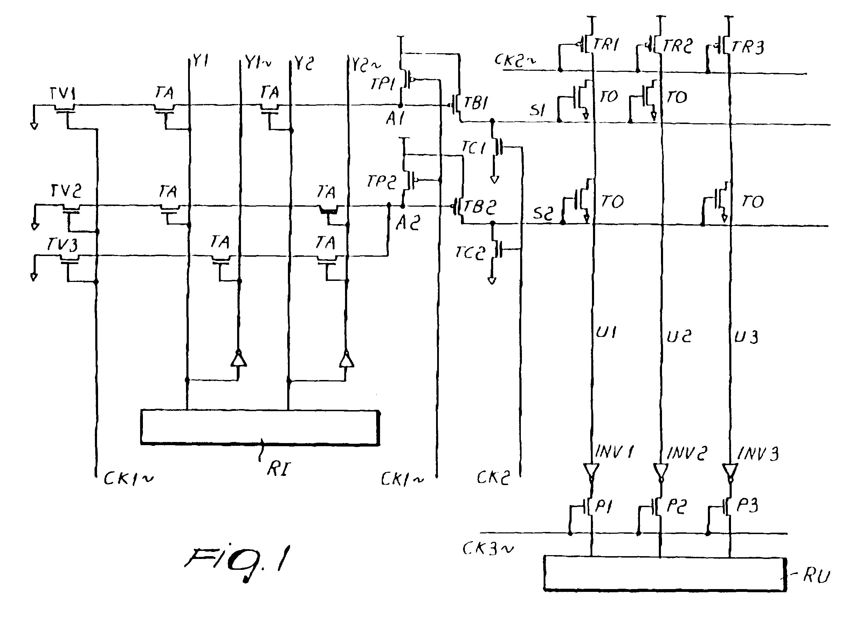

With reference to Fig. 1, a per se known input register RI is adapted to receive input data on a plurality of lines and for driving a plurality of vertical lines Y1, Y1^{∼}, Y2, Y2^{∼} which correspond to the input data and to their complements. The vertical lines Y1, Y1^{∼}, Y2, Y2^{∼} intersect horizontal lines L1, L2, L3 constituted by a plurality of N-channel transistors TA arranged in series, so as to form a so-called AND plane. At the intersection points, the vertical lines Y1, Y1^{∼}, Y2, Y2^{∼} are selectively connected to the gates of the transistors of each horizontal line, according to the required programming of the logic array, as is known in the field. Each horizontal line L1, L2, L3 thus constitutes a NAND gate which is controlled by the bit lines connected thereto.

Each of the horizontal lines L1, L2, L3 of the AND plane has one terminal thereof connected to the ground by a respective N-channel evaluation transistor of its own TV1, TV2, TV3. The gate of each of the N-channel evaluation transistors TV1, TV2, TV3 is controlled by a first clock signal CK1^{∼}. The opposite terminal of each horizontal line of the AND plane can be connected to the power supply voltage by means of a P-channel pre-loading transistor TP1, TP2. Where two adjacent horizontal lines of the AND plane are connected in parallel, as better explained hereinafter, the second terminal of each of the two horizontal lines can have a common output such as A2, which is connected to the power supply voltage by a single P-channel pre-loading transistor TP2.

A second P-channel transistor TB1, TB2 is associated with each transistor TP1, TP2, respectively. The source of the second P-channel transistor TB1, TB2 is at the power supply voltage and its gate is connected to the corresponding horizontal line of the AND plane. The gates of the transistors TP1, TP2 are all controlled by the same clock signal CK1^{∼} mentioned above.

The drains of the transistors TB1, TB2 are furthermore connected to the ground by respective N-channel transistors TC1, TC2, ..., and the gates of the transistors TC1, TC2, ... are controlled in parallel by a second clock signal CK2.

The drains of all the transistors TB1, TB2, which copy the outputs of the NAND gates of the AND plane, constitute the horizontal input lines S1, S2 of an OR plane which also comprises vertical lines U1, U2, U3. A transistor TO can be present at each intersection between the horizontal lines and the vertical lines of the OR plane, depending on the programming of the array. The gate of each transistor TO is controlled by the corresponding bit line S1, S2.

Each of the vertical lines U1, U2, U3 of the OR plane has one terminal connected to the power supply through a respective one of normally-on P-channel transistors TR1, TR2, TR3. The gates of the P-channel transistors TR1, TR2, TR3 are controlled by a third clock signal CK2^{~}which is complementary to the second clock signal CK2. The opposite terminal of each vertical line of the OR plane drives a respective inverter INV1, INV2, INV3. The output of each of the inverters INV1, INV2, INV3 is finally connected to an output register RU through a respective one of pass transistors P1, P2, P3. The gates of the pass transistors are controlled by a fourth clock signal CK3^{~}.

The number of lines entering the OR plane is thus reduced. This situation allows the horizontal extraction of the outputs without increasing the occupied space.

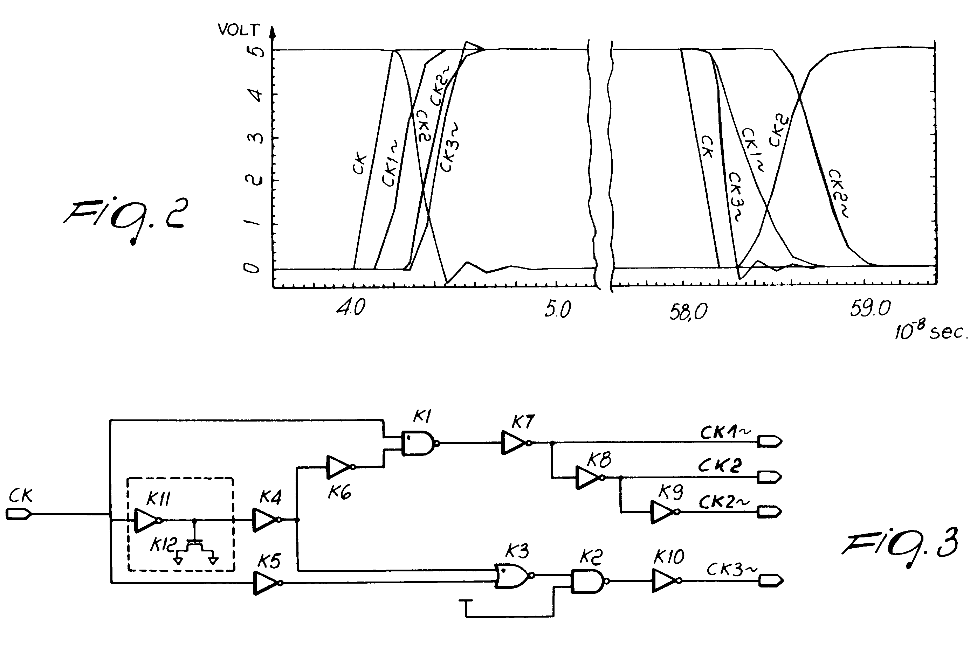

The operation of the above described logic array is now described with reference also to Fig. 2, which plots the behavior of the four clock signals CK1^{~}, CK2, CK2^{~}, CK3^{~} with reference to a master clock signal CK which times the operation of the entire system.

Immediately after the descending front of the master clock CK, the descending front of the clock signal CK3^{~} enables the pass transistors P1, P2, P3 in order to transfer the previously read data item to the latches of the output register RU. Immediately thereafter, the clock signal CK1^{~} reaches zero and starts a phase for the pre-loading of the AND plane. The signal CK1^{~}, being zero, opens the evaluation transistors TV1, TV2, TV3 and closes the pre-loading transistors TP1, TP2, whereas the input data are applied to the lines Y1, Y1^{~}, Y2, Y2^{~} and stabilized. Therefore the output nodes A1, A2 of the horizontal lines of the AND plane which are enabled by the occurrence of the combination which selects them are pre-loaded.

The transistors TB1, TB2, being driven by the NAND gates, are off. The N-channel transistors TO are also switched off by the outputs of the AND plane (drains of the transistors TB1, TB2, ....). The N-channel transistors TC for the pre-loading of the OR plane are also switched on due to the clock signal CK2 (which has a slight delay with respect to the signal CK1^{~} for disoverlapping reasons), whereas CK2^{~} simultaneously switches on the transistors TR1, TR2 as well. It can be seen that in this phase there is no static power consumption, since all the conducting paths between the power supply and the ground are open.

During the subsequent reading or evaluation phase, in which CK1^{~} has returned high, the horizontal output lines S1, S2, ... are connected to the ground by the transistors TC1, TC2 because the transistors TA switch off on one side and the transistors TC1, TC2 switch off on the other side (except for the disoverlap between CK1^{~} and CK2), because of the clock signal CK2. At this stage, since the evaluation transistors TV1, TV2, TV3 have been switched on by the signal CK1^{~}, all the paths to the ground are enabled, allowing the pre-loaded AND lines to discharge. The sense transistors TB ensure the minimum switching threshold, and thus a rapid propagation. The selected lines S1, S2 are then loaded, and each one turns on the one or more transistors TO to which it is connected. The data are detected by inverters INV1, INV2, INV3 with a high threshold in order to ensure maximum performance.

By combining a plurality of NAND lines into a wired OR configuration, according to the teachings of the invention, empty areas are created in the OR plane and allow the routing of the outputs to be less onerous by drawing said outputs at the required level. The wired-OR connections cause no deterioration in frequency performance, since in practice dynamic inversion circuits (inverters or NOR gates), formed by pairs of transistors TP, TR, are interposed between the AND plane and the OR plane. However, it is preferable to avoid exceeding the number of 4 wired-OR connected horizontal lines.

Fig. 3 illustrates a preferred circuit for generating the four clock signals CK1^{∼} , CK2, CK2^{∼}, CK3^{∼}. The circuit is formed by two NAND gates K1, K2, by a NOR gate K3, a plurality of inverters K4, K5, K6, K7, K8, K9, K10, and by a delayed inverter circuit formed by an inverter K11 with a capacitor K12 connected to the ground. An input clock signal CK, obtained from a master source, which is not illustrated, drives the circuit.

The propagation constants of the various components, with appropriate size assignments which are obvious to the expert, generate the stepped phases of clock signals illustrated in Fig. 2. The delayed inverter ensures that the clock signal for the evaluation phase has a constant preset duration for any operating frequency of the system, and in particular even at very low frequencies. After each evaluation, the array is thus immediately returned to the pre-loading phase, avoiding the leakage phenomena which would occur in case of prolonged permanence in the evaluation phase and would corrupt the data item at low frequencies.

The terms "horizontal line" and "vertical line" are expressions used for the sake of simplicity referring to the arrangement of the paths in Fig. 1, and have been used in the description and the claims only for easily distinguishing between two classes of electric paths. Similarly, the term "plane" has been used to provide a simple designation of the association of the horizontal lines and the vertical lines of the AND arrangement or the OR arrangement, and such use does not imply that such association occurs in a geometrical plane. It should be furthermore noted that all the N-channel transistors are normally off in the illustrated circuit, i.e. they are off in the absence of signal on their gate, and must receive a high signal on the gate in order to be enabled, whereas the opposite is true in the case of P-channel transistors. The polarities of all the transistors in the circuit can therefore be reversed if the polarity of the power supply voltage is also reversed.

A preferred embodiment of the invention has been described, but it is understood that the expert of the art may devise other modifications and variations.

Where technical features mentioned in any claim are followed hy reference signs, those reference signs have been included for the sole purpose of increasing the intelligibility of the claims and accordingly, such reference signs do not have any limiting effect on the scope of the claim.

## Claims

1. A CMOS programmable logic array comprising:
an input register (RI);
an output register (RU);
at least one power supply voltage terminal;
at least one reference voltage terminal (ground);
an AND plane formed by a plurality of first lines (Y) and a plurality of second lines (L), said plurality of first lines (Y) being controlled by said input register (RI), each of said plurality of second lines (L) having a first end node and a second end node, said first end node of each respective one of said plurality of second lines (L) being connected by a respective first transistor (TP) to said power supply voltage terminal, and said second end node of each respective one of said plurality of second lines (L) being connected by a respective second transistor (TV) to said reference voltage terminal (ground), each of said plurality of second lines (L) containing a plurality of third transistors (TA) connected in series, the gate of each of said third transistors (TA) in a respective one of said plurality of second lines (L) being connected to a respective selected one of said plurality of first lines (Y); and
an OR plane formed by a plurality of third lines (S) and by a plurality of fourth lines (U), each of said plurality of third lines (S) being controlled by a respective one of said plurality of second lines (L), each of said plurality of fourth lines (U) having a first end node and a second end node, the first end node of each respective one of said plurality of fourth lines (U) being connected by a respective fourth transistor (TR) to said power supply voltage terminal, the second end node of each respective one of said plurality of fourth lines (U) being connected to said output register (RU), each of said plurality of fourth lines containing at least one fifth transistor (TO), the gate of each fifth transistor (TO) in a respective one of said plurality of fourth lines (U) being connected to a respective one of said plurality of third lines (S) so that each said fifth transistor (TO) in a respective one of said plurality of fourth lines (U) is controlled by a respective one of said plurality of third lines (S), wherein
the association between at least a respective one of said plurality of second lines (L) and a respective one of said plurality of third lines (S) is formed by a respective pair of sixth transistor (TB) and seventh transistor (TC) connected in series between said power supply voltage terminal and said reference voltage terminal (ground), the gate of the sixth transistor (TB) in each pair being connected to at least a respective one of said plurality of second lines (L), the respective one of said plurality of third lines (S) being connected to the node between the sixth and seventh transistors (TB, TC) of the respective pair,
a source of a first clock pulse signal (CK1^{~}) being connected to the gate of each of the first transistors (TP) and to the gate of each of the second transistors (TV),
a source of a second clock pulse signal (CK2) being connected to the gate of the seventh transistor (TC) in each pair; and
a source of a third clock pulse signal (CK2^{~}) being connected to the gate of each of the fourth transistors (TR), wherein said second clock pulse signal (CK2) is derived from said first clock pulse signal (CK1^{~}) through a first inverter (K8) and said third clock pulse signal (CK2^{~}) is derived from said second clock pulse signal (CK2) through a second inverter (K9).

2. A CMOS programmable logic array according to claim 1, characterized in that said first, fourth, and sixth transistors (TP, TR, TB) are normally-on transistors, and said second, third, fifth and seventh transistors (TV, TA, TO, TC) are normally-off transistors.

3. A CMOS programmable logic array according to claims 1 or 2, characterized in that said second clock pulse signal (CK2) is complementary to said third clock pulse signal (CK2^{~}).

4. A CMOS programmable logic array according to one or more of claims 1-3, characterized in that second lines (L) of the AND plane which correspond to logic product terms which yield an equal value on a preset output are connected to said power supply voltage by means of a single first transistor (TP) in a wired-OR configuration.

5. A CMOS programmable logic array according to one or more of claims 1-4, characterized in that the said source of a first clock pulse signal (CK1^{~}), the said source of a second clock pulse signal (CK2) and the said source of a third clock pulse signal (CK2^{~}) are comprised by circuit means (K1-K10) which can be controlled by a clock signal (CK) in order to generate said first, second and third clock pulse signals (CK1^{~}, CK2 , CK2^{~}).

6. A CMOS programmable logic array according to claim 5, characterized in that said circuit means (K1-K10) are suitable for generating a fourth clock signal (CK3^{~}) for driving the transfer of the read data.

7. A CMOS programmable logic array according to one or more of claims 1-6, characterized in that said power supply voltage is positive, said normally-off transistors are N-channel transistors and said normally-on transistors are P-channel transistors.

## Patentansprüche

1. Programmierbares logisches Feld in CMOS-Technik umfassend:
ein Eingangsregister (Rl),
ein Ausgangsregister (RU),
wenigstens einen Spannungsversorgungsanschluß,
wenigstens einen Spannungsreferenzanschluß (Masse),
eine UND-Fläche, gebildet durch eine Vielzahl von ersten Leitungen (Y) und einer Vielzahl von zweiten Leitungen (L), wobei die Vielzahl der ersten Leitungen (Y) vom Eingangsregister (Rl) gesteuert werden, jede der Vielzahl der zweiten Leitungen (L) einen ersten und einen zweiten Endknoten aufweist, wobei jeder erste Endknoten jeder einzelnen der Vielzahl der zweiten Leitungen (L) jeweils durch einen ersten Transistor (TP) mit dem Spannungsversorgungsanschluß und jeder zweite Endknoten jeder einzelnen der Vielzahl der zweiten Leitungen (L) jeweils durch einen zweiten Transistor (TV) mit dem Referenzspannungsanschluß (Masse) verbunden ist, jede der Vielzahl der zweiten Leitungen (L) eine Vielzahl von in Reihe geschalteten dritten Transistoren (TA) aufweist, wobei das Gate eines jeden der dritten Transistoren (TA) in jeweils einer der Vielzahl der zweiten Leitungen (L) an einer ausgewählten Leitung der Vielzahl der ersten Leitungen (Y) angeschlossen ist,
einer ODER-Fläche, gebildet durch eine Vielzahl von dritten Leitungen (S) und durch eine Vielzahl von vierten Leitungen (U), wobei jede der Vielzahl der dritten Leitungen (S) jeweils durch eine der Vielzahl der zweiten Leitungen (L) gesteuert wird, jede aus der Vielzahl der vierten Leitungen (U) einen ersten Endknoten und einen zweiten Endknoten aufweist, wobei der erste Endknoten jeder einzelnen der Vielzahl der vierten Leitungen (U) jeweils durch einen vierten Transistor (TR) mit dem Spannungsversorgungsanschluß verbunden ist, der zweite Endknoten jeder einzelnen der Vielzahl der vierten Leitungen (U) mit dem Ausgangsregister (RU) verbunden ist, jede der Vielzahl der vierten Leitungen wenigstens einen fünften Transistor (TO) aufweist, wobei das Gate jedes fünften Transistors (TO) in jeweils einer der Vielzahl der vierten Leitungen (U) verbunden ist mit jeweils einer der Vielzahl der dritten Leitungen (S), so daß jeder der fünften Transistoren (TO) in jeweils einer der Vielzahl der vierten Leitungen (U) durch eine Leitung der Vielzahl der dritten Leitungen (S) gesteuert wird,
in welchem die Verbindung zwischen wenigstens jeweils einer der Vielzahl der zweiten Leitungen (L) und jeweils einer der Vielzahl der dritten Leitungen (S) jeweils durch ein Paar von sechsten Transistoren (TB) und siebten Transistoren (TC), die in Reihe zwischen dem Spannungsversorgungsanschluß und dem Referenzspannungsanschluß (Masse) geschaltet sind, gebildet ist, wobei in jedem Paar das Gate des sechsten Transistors (TB) mit wenigstens jeweils einer der Vielzahl der zweiten Leitungen (L) verbunden ist, und die jeweilige Leitung der Vielzahl der dritten Leitungen (S) an dem Knoten zwischen den sechsten und siebten Transistoren (TB, TC) des jeweiligen Paars angeschlossen ist,
ein Anschluß eines ersten Taktimpulssignafs (CK1^{~}) mit dem Gate eines jeden der ersten Transistoren (TP) und dem Gate eines jeden der zweiten Transistoren (TV) verbunden ist,
ein Anschluß eines zweiten Taktimpulssignals (CK2) mit dem Gate des siebten Transistors (TC) in jedem Paar verbunden ist;
und ein Anschluß eines dritten Taktimpulssignals (CK2^{~}) mit dem Gate eines jeden der vierten Transistoren (TR) verbunden ist, wobei das zweite Taktimpulssignal (CK2) von dem ersten Taktimpulssignal (CK1^{~}) über einen ersten Inverter (K8) abgeleitet ist und das dritte Taktimpulssignal (CK2^{~}) von dem zweiten Taktimpulssignal (CK2) über einen zweiten Inverter (K9) abgeleitet ist.

2. Programmierbares logisches Feld in CMOS-Technik nach Anspruch 1, dadurch gekennzeichnet, daß die ersten, vierten und sechsten Transistoren (TP, TR, TB) normal eingeschaltete Transistoren sind, und die zweiten, dritten, fünften und siebten Transistoren (TV, TA, TO, TC) normal ausgeschaltete Transistoren sind.

3. Programmierbares logisches Feld in CMOS-Technik nach Anspruch 1 oder 2, dadurch gekennzeichnet, daß das zweite Taktimpulssignal (CK2) komplementär zu dem dritten Taktimpulssignal (CK2^{~}) ist.

4. Programmierbares logisches Feld in CMOS-Technik nach einem oder mehreren der Ansprüche 1 bis 3, dadurch gekennzeichnet, daß die zweiten Leitungen (L) der UND-Fläche, welche mit logischen Verbindungsausdrücken korrespondieren, welche einen äquivalenten Wert an einem vorhandenen Ausgang liefern, mit der Spannungsversorgung mittels einem einzigen ersten Transistor (TP) in einer verdrahteten ODER-Konfiguration verbunden sind.

5. Programmierbares logisches Feld in CMOS-Technik nach einem oder mehreren der Ansprüche 1 bis 4, dadurch gekennzeichnet, daß der Anschluß eines ersten Taktimpulssignals (CK1^{~}), der Anschluß eines zweiten Taktimpulssignals (CK2) und der Anschluß eines dritten Taktimpulssignals (CK2^{~}) Schaltkreismittel (K1 bis K10) umfassen, welche durch ein Taktsignal (CK) gesteuert werden können, um das erste, zweite und dritte Taktimpulssignal (CK1^{~}, CK2, CK2^{~}) zu erzeugen.

6. Programmierbares logisches Feld in CMOS-Technik nach Anspruch 5, dadurch gekennzeichnet, daß die Schaltkreismittel (K1 bis K10) zum Erzeugen eines vierten Taktsignals (CK3^{~}) zum Treiben der Übertragung der Lesedaten geeignet ist.

7. Programmierbares logisches Feld in CMOS-Technik nach einem oder mehreren der Ansprüche 1 bis 6, dadurch gekennzeichnet, daß die Versorgungsspannung positiv ist, die normal ausgeschalteten Transistoren N-Kanaltransistoren sind und die normal eingeschalteten Transistoren P-Kanaltransistoren sind.

## Revendications

1. Réseau logique programmable CMOS comprenant :
un registre d'entrée (RI) ;
un registre de sortie (RU)
au moins une borne de tension d'alimentation
au moins une borne de tension de référence (masse)
un plan ET constitué d'une pluralité de premières lignes (Y) et d'une pluralité de deuxièmes lignes (L), la pluralité de premières lignes (Y) étant connectée au registre (RI), chacune de la pluralité de deuxièmes lignes (L) ayant un premier noeud d'extrémité et un deuxième noeud d'extrémité, le premier noeud d'extrémité de chacune respective de la pluralité de deuxièmes lignes (L) étant connecté par un premier transistor respectif (TP) à la borne de tension d'alimentation et le deuxième noeud de chacune respective de la pluralité de deuxièmes lignes (L) étant connecté par un deuxième transistor respectif (TV) à la borne de tension de référence (masse), chacune de la pluralité de deuxièmes lignes (L) contenant une pluralité de troisièmes transistors (TA) connectés en série, la grille de chacun des troisièmes transistors (TA) dans l'une respective de la pluralité de deuxièmes lignes (L) étant connectée à l'une choisie respective de la pluralité de premières lignes (Y) ; et
un plan OU constitué d'une pluralité de troisièmes lignes (S) et d'une pluralité de quatrièmes lignes (U), chacune de la pluralité de troisièmes lignes (S) étant commandée par l'une respective de la pluralité de deuxièmes lignes (L), chacune de la pluralité de quatrièmes lignes (U) ayant un premier noeud d'extrémité et un deuxième noeud d'extrémité, le premier noeud d'extrémité de chacune respective de la pluralité de quatrièmes lignes (U) étant connecté par un quatrième transistor respectif (TR) à la borne de tension d'alimentation, le deuxième noeud d'extrémité de chacune respective de la pluralité de quatrièmes lignes (U) étant connecté au registre de sortie (RU), chacune de la pluralité de quatrièmes lignes contenant au moins un cinquième transistor (T0), la grille de chaque cinquième transistor (T0) dans l'une respective de la pluralité de quatrièmes lignes (U) étant connectée à l'une respective de la pluralité de troisièmes lignes (S) de sorte que chacun des cinquièmes transistors (T0) dans l'une respective de la pluralité de quatrièmes lignes (U) est commandé par l'une respective de la pluralité de troisièmes lignes (S), dans lequel :
l'association entre au moins l'une respective de la pluralité de deuxièmes lignes (L) et l'une respective de la pluralité de troisièmes lignes (S) est constituée d'une paire respective d'un sixième transistor (TB) et d'un septième transistor (TC) connectés en série entre la borne de tension d'alimentation et la borne de tension de référence (masse), la grille du sixième transistor (TB) de chaque paire étant connectée à au moins l'une respective de la pluralité de deuxièmes lignes (L), l'une respective de la pluralité de troisièmes lignes (S) étant connectée au noeud entre les sixième et septième transistors (TB, TC) de la paire respective ;
une source d'un premier signal d'impulsion d'horloge (CK1^{~}) étant connectée à la grille de chacun des premiers transistors (TP) et à la grille de chacun des deuxièmes transistors (TV) ;
une source d'un deuxième signal d'impulsion d'horloge (CK2) étant connectée à la grille du septième transistor (TC) de chaque paire ; et
une source d'un troisième signal d'impulsion d'horloge (CK2^{~}) étant connectée à la grille de chacun des quatrièmes transistors (TR), le deuxième signal d'impulsion d'horloge (CK2) étant dérivé du premier signal d'impulsion d'horloge (CK1^{~}) par un premier inverseur (K8) et le troisième signal d'impulsion d'horloge (CK2^{~}) étant dérivé du deuxième signal d'impulsion d'horloge (CK2) par un deuxième inverseur (K9).

2. Réseau logique programmable CMOS selon la revendication 1, caractérisé en ce que les premier, quatrième et sixième transistors (TP, TR, TB) sont des transistors normalement passants et les deuxième, troisième, cinquième et septième transistors (TV, TA, TO, TC) sont des transistors normalement bloqués.

3. Réseau logique programmable CMOS selon la revendication 1 ou 2, caractérisé en ce que le deuxième signal d'impulsion d'horloge (CK2) est complémentaire du troisième signal d'impulsion d'horloge (CK2^{~}).

4. Réseau logique programmable CMOS selon l'une quelconque des revendications 1 à 3, caractérisé en ce que les deuxièmes lignes (L) et le plan ET qui correspondent aux termes de produits logiques qui fournissent une valeur égale sur une sortie prédéterminée sont connectés à la tension d'alimentation par un premier transistor unique (TP) en configuration de câblage OU.

5. Réseau logique programmable CMOS selon l'une quelconque des revendications 1 à 4, caractérisé en ce que la source de premier signal d'impulsion d'horloge (CK1^{~}), la source de deuxième signal d'impulsion d'horloge (CK2) et la source de troisième signal d'impulsion d'horloge (CK2^{~}) sont constituées d'un moyen de circuit (K1-K10) qui peut être commandé par un signal d'horloge (CK) pour produire les premier, deuxième et troisième signaux d'impulsion d'horloge (CK1^{~}, CK2, CK2^{~}).

6. Réseau logique programmable CMOS selon la revendication 5, caractérisé en ce que le moyen de circuit (K1-K10) est propre à produire un quatrième signal d'horloge (CK3^{~}) pour piloter le transfert de données de lecture.

7. Réseau logique programmable CMOS selon l'une quelconque des revendications 1 à 6, caractérisé en ce que la tension d'alimentation est positive, les transistors normalement bloqués sont des transistors à canal N et les transistors normalement passants sont des transistors à canal P.
